# EUROPÄISCHE PATENTSCHRIFT

(11) **EP 1 576 423 B1**
(45) Veröffentlichungstag und Bekanntmachung des Hinweises auf die Patenterteilung: **02.12.2009**
(21) Anmeldenummer: 03795872.5
(22) Anmeldetag: 05.12.2003
(51) Int. Cl.: G03F 7/30

(54) **VERFAHREN ZUM BETREIBEN EINER ENTWICKLERMASCHINE UND ENTWICKLERMASCHINE**
METHOD FOR OPERATING A DEVELOPING MACHINE AND DEVELOPING MACHINE
PROCEDE DE FONCTIONNEMENT D'UNE MACHINE A DEVELOPPER ET MACHINE A DEVELOPPER

(30) Priorität: 16.12.2002 DE 10259025
(43) Veröffentlichungstag der Anmeldung: 21.09.2005
(73) Patentinhaber: GEA Westfalia Separator GmbH, 59302 Oelde (DE)
(72) Erfinder: MACKEL, Jürgen, 59302 Oelde (DE); KLEINHAUS, Ralf, 33334 Gütersloh (DE); FUHRMANN, Martin, 84186 Vilsheim (DE); KNOBLECHNER, Helmut, 87663 Lengenwang (DE); RAUH, Wolfgang, 81377 München (DE); DIETZEL, Stephan, 06110 Halle (DE); SCHILLER, Alexander, 80634 München (DE); SCHMITT, Ulrich, 84432 Hohenpolding (DE)
(74) Vertreter: Dantz, Jan Henning
(86) Internationale Anmeldenummer: PCT/EP2003/013738
(87) Internationale Veröffentlichungsnummer: WO 2004/055595

(56) Entgegenhaltungen:
- EP-A- 0 933 684
- US-A- 4 752 283
- US-A- 5 505 863
- PATENT ABSTRACTS OF JAPAN Bd. 0182, Nr. 11 (P-1726), 14. April 1994 (1994-04-14) & JP 6 011843 A (KONICA CORP), 21. Januar 1994 (1994-01-21)
- PATENT ABSTRACTS OF JAPAN Bd. 0172, Nr. 20 (P-1529), 30. April 1993 (1993-04-30) & JP 4 353847 A (KONICA CORP), 8. Dezember 1992 (1992-12-08)

## Beschreibung

Die Erfindung betrifft ein Verfahren zum Betreiben einer Entwicklermaschine nach dem Oberbegriff des Anspruchs 1 und eine Entwicklermaschine nach dem Oberbegriff des Anspruchs 5.

Ein gattungsgemäßer Stand der Technik ist aus der DE 8406851 bekannt. Einen weiteren derartigen Stand der Technik zeigt die DE 35 34 099.

Eine vorbeschichtete, positiv arbeitende Offsetdruckplatte besteht aus einer oberflächlich definiert oxidierten Aluminiumplatte, auf die eine 2µm bis 5µm dicke lichtempfindliche Polymerschicht aufgebracht ist. Zwischen diesen Schichten befindet sich eine Siegelschicht, welche u.a. für eine vollständige Ablichtung der belichteten Polγmere sorgt. Bei den Polymeren handelt es sich in der Regel um Novolake (Phenol-Formaldehyd-Copolymerisate), die teilweise mit sulfonierten Naphthochinondiaziden verestert sind. Die Naphthochinondiaziden werden durch die Belichtung mit UV-Strahlung in die alkalisch löslichen Indencarbonsäuren überführt. Bei der Fotoreak-tion ist das Vorhandensein von Wasser erforderlich.

"Druckplatten"-Entwicklerflüssigkeiten unterscheiden sich hinsichtlich ihrer chemischen Zusammensetzung grundsätzlich von den aus der Fotografie bekannten Film- und Fotopapierentwicklern. Sie dienen im Gegensatz zu fotographischen Entwicklern nicht zur Umwandlung eines latenten in ein sichtbares Bild sondern entfernen lediglich die nach einer Belichtung löslichen Polymere der Druckplatte. Die Entwicklerlösungen bestehen im allgemeinen aus wässrigen, stark alkalischen Natriummetasilikatlösungen mit einem Anteil an Phosphaten und Netzmitteln.

Beim Gebrauch reichert sich der Entwickler mit der gelösten Indencarbonsäure an und reagiert mit dem Kohlendioxid der Luft.

Entwicklerflüssigkeiten für Negativdruckplatten können chemisch sehr unterschiedlich zusammengesetzt sein. Der Grund dafür sind die Unterschiede in den Bestandteilen der Kopierschicht der jeweiligen Druckplattenproduzenten und die Optimierung der Entwicklerlösungen auf exakt diese Druckplatten. Gemeinsam ist allen diesen Entwicklerlösungen, dass sich im Gebrauch Partikel anreichern. Trotz der üblicherweise stattfindenden Regeneration ist die Standzeit dieser Lösungen beschränkt. Ein wesentlicher Grund dafür ist die Anreicherung von festen Partikeln. Dieser Effekt wird branchenüblich als Verschlammung bezeichnet.

Die Produzenten von Druckplatten bzw. Druckplattenentwicklern empfehlen für die Verlängerung der Standzeit dieser Lösung den Einsatz sogenannter Regenerate.

Trotz des Einsatzes dieser Regenerate fallen im Betrieb große Mengen verbrauchter Entwicklerflüssigkeiten an. Deren Entsorgung ist relativ kostenaufwendig, denn die Entwicklerflüssigkeiten enthalten häufig einen nicht zu vernachlässigenden Anteil wasserlöslicher organischer Lösungsmittel und dürfen nicht in die Kanalisation abgeleitet werden.

Aufgrund dieses Aufwandes ist wünschenswert, die bei der Plattenentwicklung im Offsetdruck anfallende verbrauchte Entwicklerflüssigkeit aufzubereiten bzw. zu reinigen.

Es ist bekannt, zur Reinigung der verbrauchten Entwicklerflüssigkeit Filtrationsanlagen einzusetzen. Damit wird auch eine zufriedenstellende Reinigungswirkung erzielt. Nachteilig ist aber der relativ hohe Reinigungs- und Wartungsbedarf der Filtrationsanlagen, insbesondere aufgrund der geringen Kapazität der Filtrationsanlagen. Querstromfiltrationsanlagen könnten hier zwar Abhilfe schaffen. Deren Anschaffungskosten sind aber für den geplanten Einsatzzweck zu hoch. Problematisch ist auch, dass es nötig ist, die Filtrationsanlagen jeweils relativ genau an die jeweils verwendete Entwicklerflüssigkeit anzupassen, d.h., es ist nicht möglich, mit einer Filtrationsanlage eine Aufbereitungsvorrichtung zu realisieren, welche quasi "universell" bei verschiedensten Entwicklerflüssigkeiten von Offsetplatten einsetzbar ist.

Die Erfindung hat die Aufgabe, dieses Problem zu lösen. Die Entwicklermaschine soll derart betrieben werden, dass ihr Betrieb vereinfacht und verbilligt wird.

Die Erfindung erreicht dieses Ziel in Hinsicht auf das Verfahren durch den Gegenstand des Anspruchs 1 und in Hinsicht auf die Maschine durch den Gegenstand des Anspruchs 5.

Danach wird verunreinigte Entwicklerflüssigkeit zur Aufbereitung einer Zentrifuge, insbesondere einem Separator zugeleitet, in dessen Zentrifugalfeld zumindest ein Teil der Verunreinigungen von der Entwicklerflüssigkeit getrennt wird. Vorzugsweise wird die Zentrifuge derart ausgelegt, daß ihre auf das Produkt wirkende Beschleunigungswert (G-Zahl) am Telleraußendurchmesser größer als 5.000 ist.

Mit Hilfe des Separators kann die Entwicklerflüssigkeit so weit aufbereitet werden, dass sie wiederverwendbar ist. Dies senkt deutlich die Kosten für die Beschaffung der Entwicklerflüssigkeit gegenüber einer Lösung ohne Aufbereitung.

Gesenkt werden auch die Kosten für die Entsorgung, da die zu entsorgenden Mengen geringer werden. Hiermit verbunden sind auch die geringeren Aufwendungen für das Wechseln der Flüssigkeit, was eine unangenehme und aufwendige Arbeit darstellt, da die zu entsorgende Flüssigkeit gesundheitsschädigend sein kann.

Offenbar setzen die relativ feinen "Verschmutzungspartikel" einen Filter, der eine entsprechend feine Porengröße haben müsste, relativ schnell zu. Dieses würde sogar die relativ teuren Filter, die im Querstromverfahren arbeiten, überfordern. Der Einbau eines Filters würde daher wohl nur in Kombination mit einem speziell abgestimmten Entwickler möglich sein. Dies Problem tritt beim Einsatz eines Separators dagegen nicht auf.

Anders als mit einer Aufbereitungsvorrichtung mit Filtrationsanlage können mit dem besonders einfach einstellbaren und handhabbaren Separator also Entwicklerflüssigkeiten verschiedenster Art verarbeitet werden, ohne dass der Separator konstruktiv verändert werden müsste. Es ist lediglich ggf. notwendig, die Einstellungen des Separators an die geänderte Flüssigkeit anzupassen. Die Wartung des Separators ist einfach und kostengünstig. Darüber hinaus genügt oftmals der Einsatz eines sehr kompakten Gerätes, was es ermöglicht, die gesamte Aufbereitungsvorrichtung auf geringstem Raum unterzubringen.

Eine Abschätzung der Wirtschaftlichkeit des Verfahren hat ergeben, dass sich bei einer typischen Entwicklermaschine durch den Einsatz der Erfindung Einsparungen von bis zu einigen tausend Euro pro Jahr erzielen lassen, da der Jahresverbrauch an Entwicklerflüssigkeit deutlich (z.B. um ca. 2/3) gesenkt wird und da auch wesentlich weniger Reinigungen der Vorrichtung notwendig sind. Diese Einsparung ermöglicht die Amortisierung der Kosten der Anlage innerhalb weniger Jahre.

Nach einer Variante ist der Separator mit wechselbaren Feststoffsammelbehältern, insbesondere Kunststoffbehältern, versehen, was die Entsorgung der abseparierten Feststoffe bzw. Verunreinigungen vereinfacht.

Nachfolgend wird die Erfindung anhand von Ausführungsbeispielen unter Bezug auf die Zeichnung näher erläutert. Es zeigt:
- Fig. 1: eine schematische Darstellung einer Entwicklermaschine;
- Fig. 2: ein Verfahrensschema;
- Fig. 3: eine Schnittdarstellung eines Separators, der bei dem Verfahren der Fig. 1 einsetzbar ist;
- Fig. 4: ein Diagram, welches die Wirkung eines Filters bei der Aufbereitung der Entwicklerflüssigkeit veranschaulicht,
- Fig. 5: ein Diagram, welches die Wirkung eines Separators bei der Aufberei- tung der Entwicklerflüssigkeit veranschaulicht.
- Fig. 6: ein weiteres Diagram, welches die Wirkung eines Separators bei der Aufbereitung der Entwicklerflüssigkeit anhand der Bestimmung der Sig- nalintensität der Kopierschichtbestandteile veranschaulicht;
- Fig. 7: ein Diagram, welches die Wirkung eines Separators bei der Aufberei- tung der Entwicklerflüssigkeit anhand der Bestimmung der Leitfähigkeit der Entwicklerflüssigkeit veranschaulicht.

Die Entwicklermaschine 20 mit Maschinengestell 21- hinsichtlich des möglichen Aufbaus siehe beispielsweise die detaillierteren Ausführungen im eingangs genannten Stand der Technik - weist eine Einrichtung zur Aufbereitung von Entwicklerflüssigkeit auf, welche z.B. bei der Herstellung von Druckplatten im CTP-Verfahren (Computer-to-Plate-Verfahren) eingesetzt wird.

Die Entwicklermaschine umfasst einen Behälter 1 mit Entwicklerflüssigkeit, aus dem die Entwicklerflüssigkeit im Nebenstromverfahren durch eine Leitung 2 hier zur Grob- und Vorreinigung über ein Vorsieb 3 (z.B. 300 bis 400 µm) mittels einer Produktpumpe 4 dem Zulauf 5 eines Separators 6 zugeleitet wird. In einem hier direkt unter dem Behälter 1 angeordneten Separator 6 werden in dessen Zentrifugalfeld Verunreinigungen, insbesondere Feststoffe 7 von der übrigen Entwicklerflüssigkeit getrennt, welche durch eine Leitung 8 zurück in den Tank 1 geleitet wird. Das Vorsieb 3 dient lediglich dazu, grobe Teile vom Tellerpaket des Separators fernzuhalten.

Durch die gewählte Anordnung wird im Behälter durch die Anordnung von Zulauf (Leitung 2 nach unten) und Ablauf (Leitung 8 von der Seite) für die Entwicklerflüssigkeit eine Flüssigkeitsströmung erzeugt und aufrechterhalten, was sich im Betrieb vorteilhaft auswirkt.

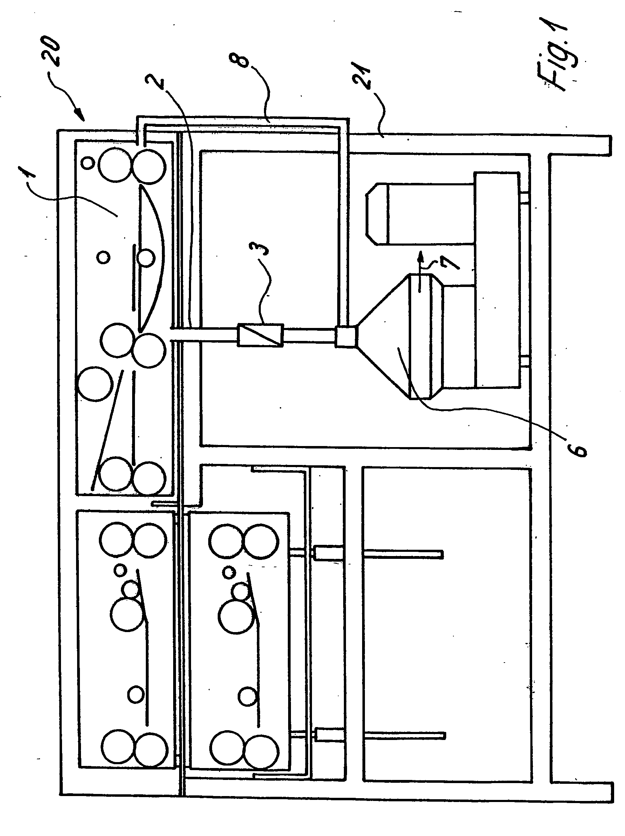

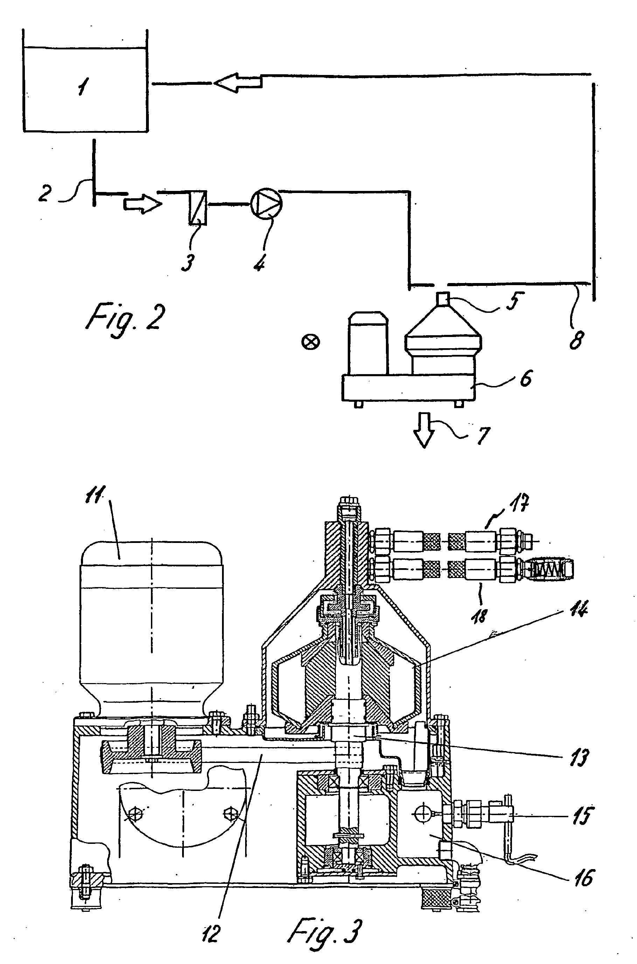

Besonders für den Einsatz im Verfahren der Fig. 1 geeignete Separatoren sind unter den Bezeichnungen "OTC2", "OSD2" und "OTC3" bei der Westfalia Mineraloil Systems GmbH, Oelde, Deutschland erhältlich. Die kompakten Kammerseparatoren mit Tellereinsatz dieses Typs weisen jeweils einen Direktantrieb mit einem Normmotor 11 und einem Flachriemen 12 auf. Die Antriebsspindel 13 und der Verteiler sind als ein gemeinsames Bauteil ausgebildet. In der Figur 3 sind rechts oben am Separator direkt untereinander der Zulauf 17 und der Ablauf 18 mit Rückschlagventil zu erkennen.

Der sich abtrennende Feststoff wird mit Hilfe eines Kunststoffeinsatzes im Trommelraum 14 periodisch z.B. per Hand (z.B. nach einigen Monaten, je nach Betriebsweise) aus der Trommel entfernt. Die geräuscharmen Separatoren des genannten Typs verfügen über eine in das Maschinengestell integrierte Überwachungseinrichtung (Überlaufsicherung), bestehend aus Schwimmerschalter 15 und einer in das Gestell integrierten Überlaufinesskammer 16. Durch diese Überwachungseinrichtung wird ein unkontrolliertes Überlaufen des Separators rechtzeitig dem Betreiber angezeigt.

Zur Reinigung der Entwicklerflüssigkeit eignet sich insbesondere der Separator OTC 2-02-137 der Anmelderin, der eine Vollmantel-Tellerkammer aufweist.

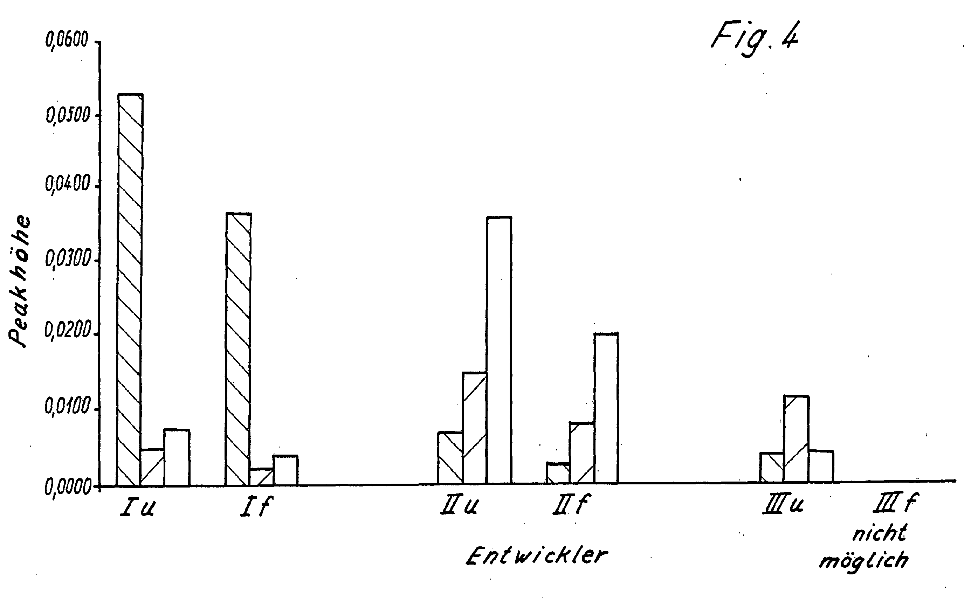

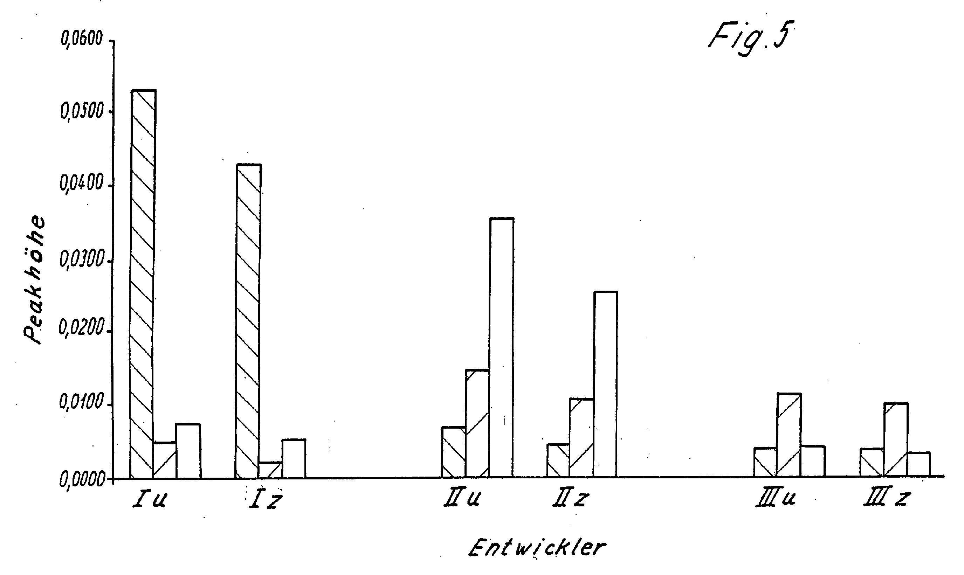

Ein Vergleich der Fig. 4 (Filtration, Messung ohne Filtration (u) und mit Filtration (f)) und Fig. 5 (Separator, Messung ohne (u) und mit Zentrifuge (z) zeigt, dass bei einem Einsatz eines Filters mit einer Porenweite von 45 µm zwar zunächst bei zwei Entwicklern I, II eine vergleichbare Verarmung an Partikeln gegeben ist wie beim Einsatz eines Separators (Nachweis: chemisch-analytisch mittels Füssigkeitschromotographie).

Andererseits ließ sich eine Entwicklerflüssigkeit (III) überhaupt nicht mit dem gewählten Filter aufbereiten. Ein mögliche Erklärung ist ein Oberflächenspannungseffekt. Dieses Problem tritt überraschend beim Einsatz von Zentrifugen nicht auf.

Da die durch Filtration entfernten Teilchen darüber hinaus zu einer extrem schnellen Verstopfung des eingesetzten Filters führt, verschlechtert sich das Diagramm der Fig. 4 in der Praxis nach nur wenigen Reinigungsvorgängen, so dass der Einsatz des Filters auch aus wirtschaftlicher Hinsicht nicht sinnvoll ist.

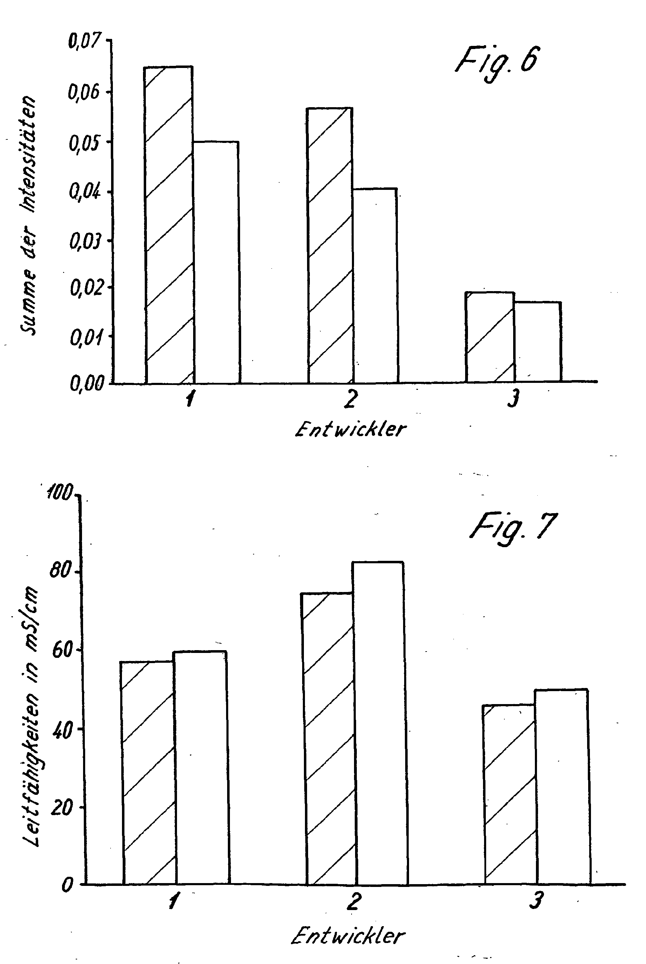

Fig. 6 veranschaulicht die Veränderung der Signalintensität der Kopierschichtbestandteile in einem Chromatogramm von verbrauchten Entwicklerlösungen (1,2,3) vor (schraffiert) und nach (unschraffiert) einer Zentrifugation. Die Chromatogramme zeigen, dass sich nach einer Zentrifugation eine Verarmung an Substanzen bzw. Verunreinigungen im Chromatogramm nachweisen lässt, die Bestandteilen der Kopierschichten zuzuordnen sind.

Parallel dazu verändert sich durch die Zentrifugation auch die Leitfähigkeit (siehe Fig. 7). Sie steigt bei allen Entwicklerflüssigkeiten wieder an, erreicht aber nicht erneut den Ausgangswert. Dies ist auch nicht zu erwarten, denn wie die Chromatogramme zeigen, nimmt der Gehalt der Kopierschichtbestandteile durch eine einmalige Zentrifugation nur um 15 bis 20% ab.

Von daher bietet es sich an, die Zentrifuge während des Betriebs der Entwicklermaschine kontinuierlich mitlaufen zu lassen und dem Behälter 1 bzw. dem Bad kontinuierlich Entwicklerflüssigkeit zu entnehmen, diese aufzubereiten und in das Bad zurück zu leiten. Alternativ ist auch ein geeignet ausgelegter Intervallbetrieb denkbar.

### Bezugszeichenliste

| | |
|---|---|
| Behälter | 1 |
| Leitung | 2 |
| Vorsieb | 3 |
| Produktpumpe | 4 |
| Zulauf | 5 |
| Separator | 6 |
| Feststoff | 7 |
| Leitung | 8 |
| Normmotor | 11 |
| Flachriemen | 12 |
| Antriebsspindel | 13 |
| Trommelraum | 14 |
| Schwimmerschalter | 15 |
| Überlaufineßkammer | 16 |
| Zulauf | 17 |
| Ablauf | 18 |

## Patentansprüche

1. Verfahren zum Betreiben einer Entwicklermaschine, bei dem unter Einsatz einer Entwicklerflüssigkeit Offset-Druckplatten hergestellt werden, **dadurch gekennzeichnet, daß** verunreinigte Entwicklerflüssigkeit zur Aufbereitung einer als nicht selbstentleerenden Kammerseparator mit Tellereinsatz ausgebildeten Zentrifuge zugeleitet wird, in deren Zentrifugalfeld zumindest ein Teil der Verunreinigungen von der Entwicklerflüssigkeit getrennt wird, wobei die Entwicklerflüssigkeit im Nebenstromverfahren einem Behälter (1) entnommen und nach dem Durchtritt durch den Separator (6) in den Behälter (1) zurückgeleitet wird.

2. Verfahren nach Anspruch 1, **dadurch gekennzeichnet, daß** die Entwicklerflüssigkeit über ein Vorsieb (3) dem Separator (6) zugeleitet wird.

3. Verfahren nach einem der vorstehenden Ansprüche, **dadurch gekennzeichnet, daß** die Abtrennung der Verunreinigungen kontinuierlich während des Betriebs erfolgt.

4. Verfahren nach einem der vorstehenden Ansprüche, **dadurch gekennzeichnet, daß** als Separator ein solcher mit einem Direktantrieb mit Flachriemen (12) verwendet wird, bei welchem Antriebsspindel (13) und Verteiler als ein einziges Bauteil ausgebildet sind.

5. Entwicklermaschine zur Herstellung von Offset-Druckplatten mit wenigstens einem Behälter (1) mit Entwicklerflüssigkeit, **dadurch gekennzeichnet, daß** der Behälter (1) mit einer als nicht selbstentleerender Kammerseparators mit Tellereinsatz ausgebildeten Zentrifuge zur Abtrennung von Verunreinigungen aus der Entwicklerflüssigkeit verbunden ist, wobei der Flüssigkeitsauslaß des Separators (6) mit dem Behälter (1) verbunden ist, um auf bereitete Entwicklerflüssigkeit in den Behälter (1) zurückzuleiten.

6. Vorrichtung nach einem der vorstehenden Ansprüche, **dadurch gekennzeichnet, daß** der Separator (6) unterhalb des Behälters (1) in einem Maschinengestell (21) angeordnet ist.

7. Vorrichtung nach einem der vorstehenden Ansprüche, **dadurch gekennzeichnet, daß** der Separator (6) mit wechselbaren Feststoffsammelbehältern, insbesondere Kunststoffbehältern, versehen ist.

8. Vorrichtung nach einem der vorstehenden Ansprüche, **dadurch gekennzeichnet, daß** im Behälter durch die Anordnung von Zulauf (Leitung 8) und Ablauf (Leitung 2) für die Entwicklerflüssigkeit eine Flüssigkeitsströmung erzeugt wird.

9. Vorrichtung nach einem der vorstehenden Ansprüche, **dadurch gekennzeichnet, daß** dem Separator (6) ein Vorsieb (3) vorgeschaltet ist.

10. Vorrichtung nach einem der vorstehenden Ansprüche, **dadurch gekennzeichnet, daß** der Separator (6) ein Kammerseparator mit Tellereinsätzen ist.

11. Vorrichtung nach einem der vorstehenden Ansprüche, **dadurch gekennzeichnet, daß** der Separator (6) einen Direktantrieb mit Flachriemen (12) aufweist.

12. Vorrichtung nach einem der vorstehenden Ansprüche, **dadurch gekennzeichnet, daß** Antriebsspindel (13) und Verteiler des Separators als ein gemeinsames Bauteil ausgebildet sind.

13. Vorrichtung nach einem der vorstehenden Ansprüche, **dadurch gekennzeichnet, daß** der Separator (6) eine Überwachungseinrichtung zum Vermeiden eines unkontrollierten Überlaufs des Separators (6) aufweist.

## Claims

1. Method for operating a developer machine, in which offset printing plates are produced, using a developer liquid, **characterized in that** contaminated developer liquid is delivered for treatment to a centrifuge which is designed as a non-self-emptying chamber separator with a tray insert and in the centrifugal field of which at least some of the impurities are separated from the developer liquid, the developer liquid being extracted from a container (1) by the bypass method and, after passing through the separator (6), being delivered back into the container (1).

2. Method according to Claim 1, **characterized in that** the developer liquid is delivered to the separator (6) via a pre-screen (3).

3. Method according to one of the preceding claims, **characterized in that** the separation of the impurities takes place continuously during operation.

4. Method according to one of the preceding claims, **characterized in that** the separator used is one with a direct drive with a flat belt (12), in which the drive spindle (13) and distributor are designed as a single component.

5. Developer machine for the production of offset printing plates, with at least one container (1) having developer liquid, **characterized in that** the container (1) is connected to a centrifuge, designed as a non-self-emptying chamber separator with a tray insert, for the separation of impurities from the developer liquid, the liquid outlet of the separator (6) being connected to the container (1), in order to deliver treated developer liquid back into the container (1).

6. Apparatus according to one of the preceding claims, **characterized in that** the separator (6) is arranged beneath the container (1) in a machine stand (21).

7. Apparatus according to one of the preceding claims, **characterized in that** the separator (6) is provided with exchangeable solids collecting containers, in particular plastic containers.

8. Apparatus according to one of the preceding claims, **characterized in that** a liquid flow is generated in the container by means of the arrangement of an inflow (line 8) and an outflow (line 2) for the developer liquid.

9. Apparatus according to one of the preceding claims, **characterized in that** the separator (6) is preceded by a pre-screen (3).

10. Apparatus according to one of the preceding claims, **characterized in that** the separator (6) is a chamber separator with tray inserts.

11. Apparatus according to one of the preceding claims, **characterized in that** the separator (6) has a direct drive with a flat belt (12).

12. Apparatus according to one of the preceding claims, **characterized in that** the drive spindle (13) and the distributor of the separator are designed as one common component.

13. Apparatus according to one of the preceding claims, **characterized in that** the separator (6) has a monitoring device for avoiding an uncontrolled overflow of the separator (6).

## Revendications

1. Procédé de fonctionnement d'une développeuse, dans le cadre duquel des plaques d'impression offset sont confectionnées en utilisant un liquide de développement, **caractérisé en ce que** le liquide de développement contaminé par des impuretés est amené pour retraitement à une centrifugeuse, réalisée sous la forme d'un séparateur à chambres non autodéchargeur avec plateau amovible, dans la zone de centrifugation de laquelle les impuretés sont séparées au moins en partie du liquide de développement, ledit liquide de développement étant prélevé dans un réservoir (1) par le biais d'un système en dérivation et renvoyé dans le réservoir (1) après être passé dans le séparateur (6).

2. Procédé selon la revendication 1, **caractérisé en ce que** le liquide de développement est amené au séparateur (6) en passant par un préfiltre (3).

3. Procédé selon l'une quelconque des revendications précédentes, **caractérisé en ce que** la séparation des impuretés se fait en continu pendant le fonctionnement.

4. Procédé selon l'une quelconque des revendications précédentes, **caractérisé en ce que** le séparateur utilisé est un séparateur à entraînement direct par courroie plate (12) dans lequel l'axe d'entraînement (13) et le distributeur sont réalisés sous la forme d'une pièce unique.

5. Développeuse servant à confectionner des plaques d'impression offset, avec au moins un réservoir (1) contenant le liquide de développement, **caractérisé en ce que** le réservoir (1) est relié à une centrifugeuse, réalisée sous la forme d'un séparateur à chambres non autodéchargeur avec plateau amovible, afin de séparer les impuretés du liquide de développement, la sortie de liquide du séparateur (6) étant reliée au réservoir (1) afin de renvoyer le liquide de développement retraité dans le réservoir (1).

6. Dispositif selon l'une quelconque des revendications précédentes, **caractérisé en ce que** le séparateur (6) est disposé en dessous du réservoir (1) dans un châssis (21) de la machine.

7. Dispositif selon l'une quelconque des revendications précédentes, **caractérisé en ce que** le séparateur (6) est équipé de récipients de collecte de solides interchangeables, en particulier de récipients en matière plastique.

8. Dispositif selon l'une quelconque des revendications précédentes, **caractérisé en ce qu'**une circulation de liquide est générée dans le réservoir par la disposition de l'entrée (conduite 8) et de la sortie (conduite 2) du liquide de développement.

9. Dispositif selon l'une quelconque des revendications précédentes, **caractérisé en ce qu'**un préfiltre (3) est monté en amont du séparateur (6).

10. Dispositif selon l'une quelconque des revendications précédentes, **caractérisé en ce que** le séparateur (6) est un séparateur à chambres à plateaux amovibles.

11. Dispositif selon l'une quelconque des revendications précédentes, **caractérisé en ce que** le séparateur (6) présente un entraînement direct par courroie plate (12).

12. Dispositif selon l'une quelconque des revendications précédentes, **caractérisé en ce que** l'axe d'entraînement (13) et le distributeur du séparateur sont réalisés sous la forme d'une pièce d'un seul tenant.

13. Dispositif selon l'une quelconque des revendications précédentes, **caractérisé en ce que** le séparateur (6) présente un dispositif de surveillance destiné à empêcher un débordement incontrôlé du séparateur (6).
